# EUROPEAN PATENT SPECIFICATION

(11) **EP 4 362 620 B1**
(45) Date of publication and mention of the grant of the patent: **16.09.2026**
(21) Application number: 22204695.5
(22) Date of filing: 31.10.2022
(51) Int. Cl.: H05K 7/20

(54) **ELECTRONIC CONTROL UNIT**
ELEKTRONISCHE STEUEREINHEIT
UNITÉ DE COMMANDE ÉLECTRONIQUE

(43) Date of publication of application: 01.05.2024
(73) Proprietor: Aptiv Technologies AG, 8200 Schaffhausen (CH)
(72) Inventor: RADEMACHER, Falk, 51647 Gummersbach (DE); REINHOLD, Peter, 51647 Gummersbach (DE)
(74) Representative: Bardehle Pagenberg Partnerschaft mbB Patentanwälte Rechtsanwälte

(56) References cited:
- EP-A1- 3 270 410
- EP-A2- 2 814 057
- US-A1- 2004 262 372
- US-A1- 2016 315 030

## Description

### 1. Technical field

The present disclosure relates to a method for manufacturing an electronic control unit, a method for manufacturing multiple electronic control units, and an electronic control unit.

### 2. Prior art

An electronic control unit, also known as an ECU, is an embedded system in automotive electronics that controls one or more of the electrical systems and/or subsystems in a car or any other vehicle. A reliable operation of electronic control units is critical for the safety and/or the functionality of the vehicle. This is especially true for electrically driven vehicles. Accordingly, this topic is becoming increasingly important. Usually, an ECU comprises at least one electric component. Thereby most utilized electric components generate thermal energy. Some electric components generate thermal energy to an extent that external cooling is required. If this thermal energy is not dissipated, it may cause defects to develop on their own. Hence, an uncooled or insufficiently cooled electric component, such as an integrated circuit, can be damaged and/or shut itself down. Accordingly, a sufficient and reliable cooling must be provided for electric components which generate a certain amount of thermal energy. An example of a method for manufacturing an electronic control unit is disclosed by the document EP3270410, Laird Technologies, published on 17 January 2018.

A general solution used in practice for cooling an electric component of an ECU is the use of a heat sink thermally connected to the electric component. Said heat sink may exemplarily comprise cooling ribs and/or flow channels for guiding a cooling medium such as air, oil, and/or water. Regularly, said heat sink is not directly thermally connected to the electric component. Rather, a heat spreader is connected to the electric component, and the heat sink is stacked on top of the heat spreader. In the following two particular solutions based on the described general solution are described together with their drawbacks.

According to a first particular solution an ECU comprises a housing with an integrally formed heat spreader being a protrusion directing to the inside of the housing and towards a top surface of an electric component which is attached to a printed circuit board (PCB). Accordingly, a heat sink is contacted with an outside surface of the housing. To enable a transfer of thermal energy from the electric component to said integrally formed heat spreader, a layer of thermal interface material, also known as TIM, is arranged in a gap between the electric component and the heat spreader.

The first particular solution has the disadvantage that said gap has relatively high tolerances compared to the thickness and/or compressibility of common thermal interface materials. This is as several individual tolerances contribute to the tolerance of the gap. Exemplarily tolerances of the electric component on the PCB, of the heat spreader/housing, and/or of the PCB. Since the transfer of thermal energy is highly dependent on the gap size and the related compression of the layer of thermal interface material, it is hardly possible to provide a predictable cooling performance for the electric component. Moreover, the high tolerances entail the risk that for a very small gap, the TIM is compressed to such an extent that the electric component is damaged.

According to a second particular solution, which is exemplarily suggested by US 2016/155682 A1, an ECU is provided which allows a separate and individually dimensioned heat spreader to be arranged between an electric component and a heat sink. Therefor an opening into which the heat spreader can be inserted is provided in a housing of the ECU. The individually dimensioned heat spreader is selected after a measurement such that manufacturing tolerances are at least partially compensated. Hence, gaps which need to be filled with thermal interface material, e.g., between the electric component and the heat spreader and/or between the heat spreader and the heat sink, can be provided with relatively small tolerances. Thus, the drawbacks of the first particular solution may be partially overcome.

However, the provision of individually dimensioned heat spreaders according to the second particular solution involves considerable manufacturing efforts. This is as the heat spreaders, which are regularly metal blocks, must be individually milled, which per se leads to high manufacturing efforts.

Thus, it is an object of the present disclosure to provide a method for manufacturing an electronic control unit, a method for manufacturing multiple electronic control units, and an electronic control unit that overcome the aforementioned drawbacks at least partially.

### 3. Summary of the invention

This object is achieved, at least partly, by a method for manufacturing an electronic control unit, a method for manufacturing multiple electronic control units, and an electronic control unit, as defined in the independent claims. Further aspects of the present disclosure are defined in the dependent claims.

In particular, the object is achieved by a method for manufacturing an electronic control unit. The method comprises the following steps in the given order: (A) providing a printed circuit board with at least one electric component attached thereon; (B) arranging a lower layer of thermal interface material on top of the electric component; (C) arranging an integrated heat spreader on top of the lower layer; (D) determining the distance of the top surface of the integrated heat spreader perpendicular to the printed circuit board; (E) arranging an upper layer of thermal interface material on the top surface of the integrated heat spreader, wherein a layer thickness of the upper layer is selected based on the determined distance, and arranging a heat sink with a contact surface such that the contact surface contacts the upper layer.

The at least one electric component may comprise an electronic component such as an integrated circuit.

Further, thermal interface material, which may be also referred to as TIM, can be any material that may be inserted between two components to enhance the thermal coupling between them. Said thermal interface material may comprise a thermal paste, a thermal adhesive, a thermal gap filler, a thermally conductive pad, a thermal tape, a phase-change material (PCM), and/or a metal thermal interface material. Additional options for thermal interface material are described throughout the present disclosure.

The lower layer is optionally chosen to be relatively thin compared to the upper layer. Thus, heat from the electric component may transfer easily into the heat spreader. Hence, the heat spreader can already provide a certain buffer function for heat dissipation.

Further, the integrated heat spreader may serve to transfer heat energy from the hotter electric component to the colder heat sink. The integrated heat spreader may comprise a plate or a block of a material having high thermal conductivity. Respective materials are described throughout the following.

Moreover, the distance of the top surface of the integrated heat spreader perpendicular to the printed circuit board may be determined directly and/or indirectly. Exemplarily a height difference between the top surface of the integrated heat spreader and a top surface of the printed circuit board may be measured. Further exemplarily, a height difference between the top surface of the integrated heat spreader and a top surface of another element attached to the printed circuit board may be measured.

That the layer thickness of the upper layer is selected based on the determined distance may refer to the aspect that for a greater determined distance a thinner layer is selected than for a smaller determined distance. This is as a greater determined distance may indicate that a gap which is to be filled is relatively small compared to a smaller determined distance.

The heat sink which may be also referred to as a heat-dissipating device for transferring thermal energy from a higher-temperature surface, e.g., of the upper layer, to a lower-temperature fluid medium. Said fluid medium may comprise air, water, refrigerants and/or oil. If the fluid medium comprises water, the heat sink may be also referred to as a cold plate.

The method has several advantages, wherein two of them are described in further detail. First, by selecting the layer thickness of the upper layer based on the determined distance it is possible to precisely adapt the layer thickness of the upper layer with regards to tolerances of the electronic control unit. Thus, a predictable and/or increased cooling performance can be achieved. Exemplarily a tolerance of a height of the electric component on the printed circuit board and/or of a thickness of the integrated heat spreader may be taken into consideration when selecting the layer thickness of the upper layer. Second, by selecting the layer thickness of the upper layer based on the determined distance manufacturing may be simplified. This is as the layer thickness of the upper layer may be selected from commercially available layers of thermal interface material. Hence, an individual manufacturing of an integrated heat spreader can be avoided. Only a punching in the required shape from a commercially available layer may be required. It is understood that these advantages may also apply for the following.

The method may further comprise the step of attaching a housing on the printed circuit board, wherein the housing comprises a through hole which is configured to receive the integrated heat spreader at least partially, wherein said step is optionally performed prior to the step of arranging the integrated heat spreader on top of the lower layer. By means of the through hole the integrated heat spreader may be hold in position by the housing. Hence, assembly may be facilitated. Moreover, the housing may provide for an additional heat transfer. It is understood that the step of attaching the housing on the printed circuit board may not necessarily be performed directly prior to the step of arranging the integrated heat spreader on top of the lower layer.

Determining the distance of the top surface of the integrated heat spreader relative to the printed circuit board may comprise measuring a height difference between a top surface of the housing and the top surface of the integrated heat spreader. This allows to adapt the layer thickness of the upper layer with regards to tolerances of the electronic control unit even more precisely. This is as the height difference between the top surface of the housing on which the heat sink is arranged, and the top surface of the integrated heat spreader represents the dimension of the gap which must be filled by the upper layer. Accordingly, tolerances which may result from attaching the printed circuit board to the housing may be taken into consideration. It is to be noted that on top of the housing a layer of thermal interface material may be attached. Hence, the top surface of the housing may be a surface of the thermal interface material attached to the housing.

The upper layer may comprise a thermally conductive compressible material and/or a compressible material with a thermally conductive wrapping layer, wherein the wrapping layer optionally comprises a graphite layer, wherein further optionally the graphite layer has a thickness which lies in a range from 10 µm to 40 µm and even further optionally from 20 µm to 30 µm. The thermally conductive compressible material and/or the compressible material may comprise a foam. Particularly the option of the compressible material with the thermally conductive wrapping layer has proven to be advantageous as it allows for compensating the tolerances in the observed ranges and at the same time provides substantially constant heat transfer properties.

The layer thickness of the upper layer may lie in a range from 0.1 mm to 10 mm, optionally from 0.2 mm to 5 mm, further optionally from 0.4 mm to 1.8 mm, and even further optionally from 1 mm to 1.2 mm. These layer thicknesses allow reliable gap filling and tolerance compensation for most applications, while avoiding excessive pressure on the electric component.

A ratio of the layer thickness of the upper layer to a layer thickness of the lower layer may lie in a range from 1 to 60, optionally from 1.5 to 20, further optionally from 1.8 to 10, even further optionally from 2 to 7, and even more optionally from 3 to 5. These ratios have proven to be advantageous in that they allow for a good heat transfer especially with the above-mentioned layer thicknesses.

The above object is also achieved by a method for manufacturing multiple electronic control units. The method comprises the step of repeating the method steps of the above-described method multiple times for manufacturing multiple electronic control units, wherein each time an integrated heat spreader with the same thickness is arranged. This method particularly allows that an individual manufacturing of integrated heat spreaders is avoided. Rather, exemplarily only a punching in the required shape from a commercially available layer of thermal interface material is necessary to provide the upper layer in the required thickness.

Optionally, in the above-described methods, a first material with a thermal conductivity K₁ is selected for the upper layer if a distance d₁ of the top surface of the integrated heat spreader perpendicular to the printed circuit board is determined, wherein a second material with a thermal conductivity K₂ which is higher than the thermal conductivity K₁ is selected for the upper layer if a distance d₂ of the top surface of the integrated heat spreader perpendicular to the printed circuit board is determined, wherein the distance d₂ is larger than the distance d₁. This allows that larger gaps can be better bridged thermally, and smaller gaps can be fitted with a less complex and therefore less expensive material. It is understood that vice versa a lower thermal conductivity will be selected for the second material in case the distance d₂ is shorter.

Further, the above-mentioned object is achieved by an electronic control unit. Since the above-described methods also refer to an electronic control unit, it is understood that the advantages and/or technical aspects which are described with regards to the methods may also apply for the electronic control unit described below and vice versa.

The electronic control unit comprises a printed circuit board with a first and a second electric component attached thereon. The first and/or the second electric component may be configured as the electric component as described above regarding the method. Hence, they may each comprise an integrated circuit. The skilled person will understand that the printed circuit board may comprise a variety of further electric components.

Further, the electronic control unit comprises a heat sink with a contact surface facing the printed circuit board. It is understood that the heat sink may be configured as described above regarding the method.

Moreover, the electronic control unit comprises a first integrated heat spreader arranged between the first electric component and the heat sink, and a second integrated heat spreader arranged between the second electric component and the heat sink, wherein the first integrated heat spreader has substantially the same thickness as the second integrated heat spreader. By the first integrated heat spreader having substantially the same thickness as the second integrated heat spreader manufacturing may be facilitated compared to a solution where integrated heat spreaders are provided with individual thicknesses to compensate for tolerances within the ECU.

Furthermore, the electronic control unit comprises a first lower layer of thermal interface material arranged between the first electric component and the first integrated heat spreader, and a second lower layer of thermal interface material arranged between the second electric component and the second integrated heat spreader.

Even further, the electronic control unit comprises a first upper layer of thermal interface material arranged between the first integrated heat spreader and the heat sink, and a second upper layer of thermal interface material arranged between the second integrated heat spreader and the heat sink.

The first electric component is less high than the second electric component when measured from the printed circuit board, and the first lower layer is thicker than the second lower layer and/or the first upper layer is thicker than the second upper layer. Exemplarily, the first electric component may be less high than the second electric component due to manufacturing tolerances and/or due to a difference of the electric components.

Further, the first lower layer may have substantially the same thickness as the second lower layer and the first upper layer may be thicker than the second upper layer. Hence, the first upper layer and/or the second upper layer compensate for the first electric component being less high than the second electric component. Thereby a precise compensation of tolerances is possible particularly when compared to the first particular prior art solution.

Moreover, the electronic control unit may further comprise a housing attached to the printed circuit board, wherein the housing comprises a first opening in which the first integrated heat spreader is at least partially arranged and a second opening in which the second integrated heat spreader is at least partially arranged. The advantages and/or technical aspects which are described with regards to the methods apply here.

The first and/or the second upper layer may comprise a thermally conductive and compressible material and/or a compressible material with a thermally conductive wrapping layer, wherein the wrapping layer optionally comprises a graphite layer, wherein further optionally the graphite layer has a thickness which lies in a range from 10 µm to 40 µm and even further optionally from 20 µm to 30 µm. The advantages and/or technical aspects which are described with regards to the methods apply here.

The first upper layer may comprise a first material and the second upper layer may comprise a second material, wherein the thermal conductivity of the first material is different from the thermal conductivity of the second material, wherein optionally the thermal conductivity of the first material is higher than the thermal conductivity of the second material. This allows that larger gaps can be better bridged thermally, and smaller gaps can be fitted with a less complex and therefore less expensive material.

The integrated heat spreader, the first integrated heat spreader, and/or the second integrated heat spreader may comprise aluminum, copper, ceramics, metal oxide, graphite, gold, silver and/or combinations thereof, wherein optionally the integrated heat spreader, the first integrated heat spreader, and/or the second integrated heat spreader comprise a cylindrical shape or a rectangular cuboid shape. These materials allow for a sufficient heat transfer while the mentioned shapes allow for a facilitated manufacturing and/or assembly.

The heat sink may be configured for passive and/or active heat exchange, wherein optionally the heat sink is configured for a solid, a gaseous and/or a fluid heat exchange medium.

### 4. Brief description of the accompanying figures

In the following, the accompanying figures are briefly described:
Fig. 1 shows a diagram of a method for manufacturing an electronic control unit according to the present invention;
Fig. 2 shows a diagram of a method for manufacturing multiple electronic control units;
Fig. 3a and 3b partially illustrate the method for manufacturing an electronic control unit by means of a respective electronic control unit in perspective view;
Fig. 4a and 4b illustrate the subject-matter of Fig. 3a and 3b in a side cut view;
Fig. 5a and 5b correspond to Fig. 4a and 4b, wherein the electric component is higher relative to the printed circuit board, and
Fig. 6 shows an electronic control unit according to the present invention.

### 5. Detailed description of the figures

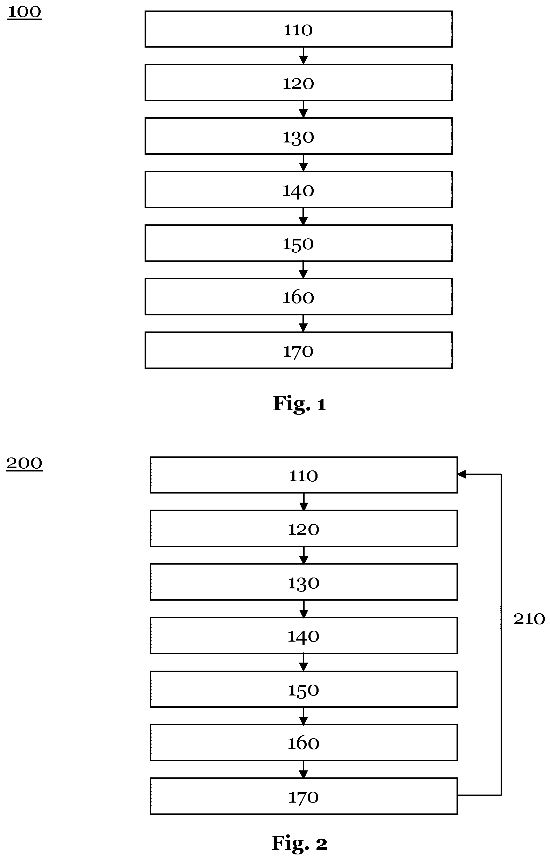

**Fig. 1** shows a diagram of a method 100 for manufacturing an electronic control unit 1; 2. The method 100 comprising the following steps in the given order:
- Providing 110 a printed circuit board 10 with at least one electric component 12, 14 attached thereon.
- Arranging 120 a lower layer 20, 30 of thermal interface material on top of the electric component 12, 14.
- Attaching 130 a housing 90 on the printed circuit board 10, wherein the housing 90 comprises a through hole 92, 94 which is configured to receive the integrated heat spreader 40, 50 at least partially.
- Arranging 140 an integrated heat spreader 40, 50 on top of the lower layer 20, 30 and inside the through hole 92, 94.
- Determining 150 the distance of the top surface 41, 51 of the integrated heat spreader 40, 50 perpendicular to the printed circuit board 10. Determining the distance of the top surface 41, 51 of the integrated heat spreader 40, 50 relative to the printed circuit board 10 preferably comprises measuring a height difference between a top surface 91 of the housing 90 and the top surface 41, 51 of the integrated heat spreader 40, 50.
- Arranging 160 an upper layer 60, 70 of thermal interface material on the top surface 41, 51 of the integrated heat spreader 40, 50, wherein a layer thickness of the upper layer 60, 70 is selected based on the determined distance.
- Arranging 170 a heat sink 80 with a contact surface 81 such that the contact surface 81 contacts the upper layer 60, 70.

**Fig. 2** shows a diagram of a method 200 for manufacturing multiple electronic control units, wherein the method 200 comprises the step of repeating 210 the method steps of the method 100.

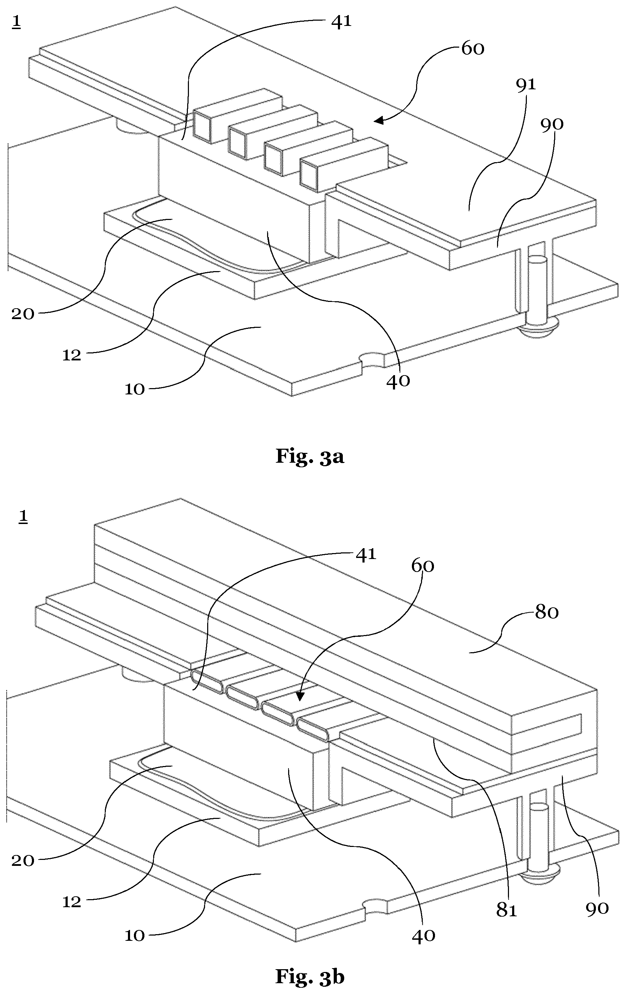

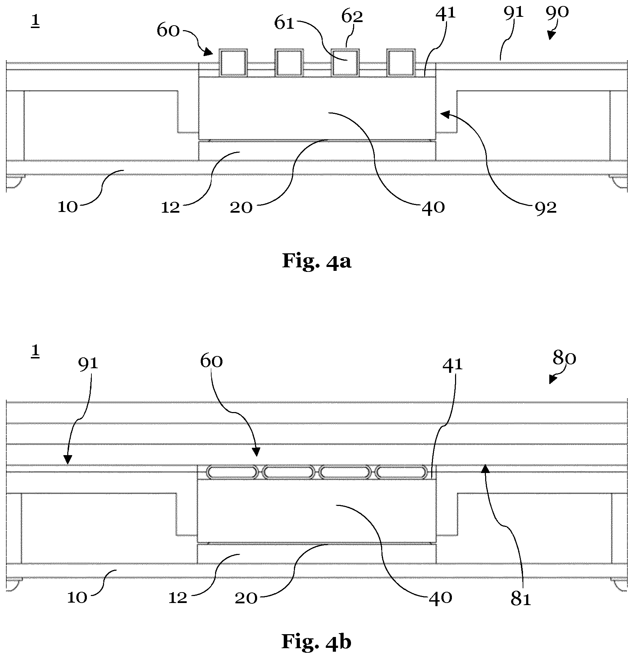

**Fig. 3a****/****Fig. 4a** illustrate the electronic control unit 1 before the heat sink 80 has been arranged, wherein **Fig. 3b****/****Fig. 4b** illustrate the electronic control unit 1 after the heat sink 80 has been arranged. As shown, the upper layer 60 is compressed after the heat sink is arranged on the top surface 91 of the housing 90. Said upper layer 60 comprises several elements of compressible material 61 with a thermally conductive wrapping layer 62. Due to the compression the contact surface between the heat spreader 40 and the upper layer 60 increases.

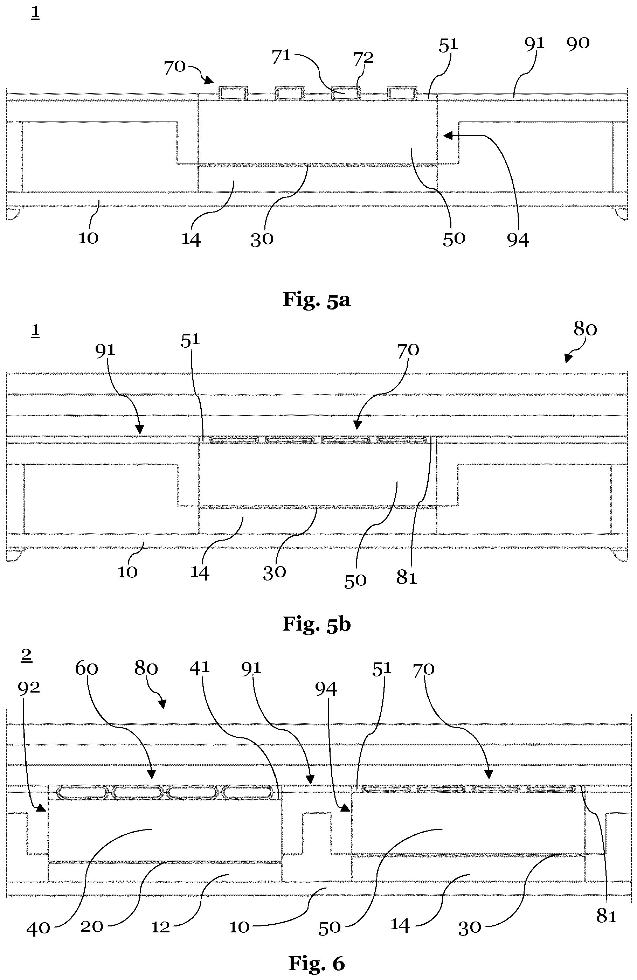

**Fig. 5a and 5b** in comparison to **Fig. 4a and 4b** particularly illustrate that the layer thickness of the upper layer 60, 70 is selected based on the determined distance of the top surface 41, 51 of the integrated heat spreader 40, 50 perpendicular to the printed circuit board 10. Moreover, it can be derived that the integrated heat spreaders 40, 50 have the same thickness.

**Fig. 6** shows an electronic control unit 2, comprising a printed circuit board 10 with a first 12 and a second 14 electric component attached thereon. Thereby the first electric component 12 is less high than the second electric component 14 when measured from the printed circuit board 10.

The ECU 2 further comprises a heat sink 80 with a contact surface 81 facing the printed circuit board 10. Moreover, the ECU 2 comprises a first integrated heat spreader 40 and a second integrated heat spreader 50 which substantially have the same thickness. Hence, they may be manufactured by means of exactly the same manufacturing process.

Further, the ECU 2 comprises a first lower layer 20 of thermal interface material, a second lower layer 30 of thermal interface material, a first upper layer 60 of thermal interface material, and a second upper layer 70 of thermal interface material. Thereby the first lower layer 20 has substantially the same thickness as the second lower layer 30 and the first upper layer 60 is thicker than the second upper layer 70.

Moreover, a housing 90 is attached to the printed circuit board 10, wherein the housing 90 comprises a first opening 92 in which the first integrated heat spreader 40 is at least partially arranged and a second opening 94 in which the second integrated heat spreader 50 is at least partially arranged.

### List of reference signs

- 1; 2: electronic control unit
- 10: printed circuit board
- 12, 14: electric component
- 20, 30: lower layer of thermal interface material
- 40, 50: integrated heat spreader
- 41, 51: top surface of the integrated heat spreader
- 60, 70: upper layer of thermal interface material
- 61, 71: compressible material
- 62, 72: thermally conductive wrapping layer
- 80: heat sink
- 81: contact surface of the heat sink
- 90: housing
- 91: top surface of the housing
- 92, 94: through hole of the housing

- 100: method for manufacturing an electronic control unit
- 110: providing printed circuit board
- 120: arranging lower layer
- 130: attaching housing
- 140: arranging integrated heat spreader
- 150: determining distance
- 160: arranging upper layer
- 170: arranging heat sink

- 200: method for manufacturing multiple electronic control units
- 210: repeating method steps of method 100

## Claims

1. A method (100) for manufacturing an electronic control unit (1; 2), the method (100) comprising the following steps in the given order:
providing (110) a printed circuit board (10) with at least one electric component (12, 14) attached thereon;
arranging (120) a lower layer (20, 30) of thermal interface material on top of the electric component (12, 14);
arranging (140) an integrated heat spreader (40, 50) on top of the lower layer (20, 30);
determining (150) the distance of the top surface (41, 51) of the integrated heat spreader (40, 50) perpendicular to the printed circuit board (10);
arranging (160) an upper layer (60, 70) of thermal interface material on the top surface (41, 51) of the integrated heat spreader (40, 50), wherein a layer thickness of the upper layer (60, 70) is selected based on the determined distance, and
arranging (170) a heat sink (80) with a contact surface (81) such that the contact surface (81) contacts the upper layer (60, 70).

2. The method (100) according to the preceding claim, wherein the method (100) further comprises the step of
attaching (130) a housing (90) on the printed circuit board (10), wherein the housing (90) comprises a through hole (92, 94) which is configured to receive the integrated heat spreader (40, 50) at least partially, wherein said step (130) is optionally performed prior to the step of arranging (140) the integrated heat spreader (40, 50) on top of the lower layer (20, 30).

3. The method (100) according to the preceding claim, wherein determining the distance of the top surface (41, 51) of the integrated heat spreader (40, 50) relative to the printed circuit board (10) comprises measuring a height difference between a top surface (91) of the housing (90) and the top surface (41, 51) of the integrated heat spreader (40, 50).

4. The method (100) according to any one of the preceding claims, wherein the upper layer (60, 70) comprises
a thermally conductive compressible material and/or
a compressible material (61, 71) with a thermally conductive wrapping layer (62, 72), wherein the wrapping layer (62, 72) optionally comprises a graphite layer, wherein further optionally the graphite layer has a thickness which lies in a range from 10 µm to 40 µm and even further optionally from 20 µm to 30 µm.

5. The method (100) according to any one of the preceding claims, wherein the layer thickness of the upper layer (60, 70) lies in a range from 0.1 mm to 10 mm, optionally from 0.2 mm to 5 mm, further optionally from 0.4 mm to 1.8 mm, and even further optionally from 1 mm to 1.2 mm.

6. The method (100) according to any one of the preceding claims, wherein a ratio of the layer thickness of the upper layer (60, 70) to a layer thickness of the lower layer (20, 30) lies in a range from 1 to 60, optionally from 1.5 to 20, further optionally from 1.8 to 10, even further optionally from 2 to 7, and even more optionally from 3 to 5.

7. A method (200) for manufacturing multiple electronic control units (1; 2), wherein the method (200) comprises the step of
repeating (210) the method steps of the method (100) according to any one of claims 1 to 6 multiple times for manufacturing multiple electronic control units, wherein each time an integrated heat spreader with the same thickness is arranged.

8. The method (100; 200) according to any one of the preceding claims, wherein a first material with a thermal conductivity K₁ is selected for the upper layer (60, 70) if a distance d₁ of the top surface (41, 51) of the integrated heat spreader (40, 50) perpendicular to the printed circuit board (10) is determined, wherein a second material with a thermal conductivity K₂ which is higher than the thermal conductivity K₁ is selected for the upper layer (60, 70) if a distance d₂ of the top surface (41, 51) of the integrated heat spreader (40, 50) perpendicular to the printed circuit board (10) is determined, wherein the distance d₂ is larger than the distance d₁.

9. An electronic control unit (2), comprising:
a printed circuit board (10) with a first (12) and a second (14) electric component attached thereon;
a heat sink (80) with a contact surface (81) facing the printed circuit board (10);
a first integrated heat spreader (40) arranged between the first electric component (12) and the heat sink (80), and a second integrated heat spreader (50) arranged between the second electric component (14) and the heat sink (80), wherein the first integrated heat spreader (40) has substantially the same thickness as the second integrated heat spreader (50);
a first lower layer (20) of thermal interface material arranged between the first electric component (12) and the first integrated heat spreader (40), and a second lower layer (30) of thermal interface material arranged between the second electric component (14) and the second integrated heat spreader (50), and
a first upper layer (60) of thermal interface material arranged between the first integrated heat spreader (40) and the heat sink (80), and a second upper layer (70) of thermal interface material arranged between the second integrated heat spreader (50) and the heat sink (80),
wherein the first electric component (12) is less high than the second electric component (14) when measured from the printed circuit board (10), and wherein the first lower layer (20) is thicker than the second lower layer (30) and/or wherein the first upper layer (60) is thicker than the second upper layer (70).

10. The electronic control unit (2) according to the preceding claim, wherein the first lower layer (20) has substantially the same thickness as the second lower layer (30) and wherein the first upper layer (60) is thicker than the second upper layer (70).

11. The electronic control unit (2) according to any one of the preceding claims, wherein the electronic control unit (2) further comprises
a housing (90) attached to the printed circuit board (10), wherein the housing (90) comprises a first opening (92) in which the first integrated heat spreader (40) is at least partially arranged and a second opening (94) in which the second integrated heat spreader (50) is at least partially arranged.

12. The electronic control unit (2) according to any one of the preceding claims, wherein the first (60) and/or the second (70) upper layer comprise
a thermally conductive and compressible material and/or
an compressible material (61, 71) with a thermally conductive wrapping layer (62, 72), wherein the wrapping layer (62, 72) optionally comprises a graphite layer, wherein further optionally the graphite layer has a thickness which lies in a range from 10 µm to 40 µm and even further optionally from 20 µm to 30 µm.

13. The electronic control unit (2) according to any one of the preceding claims, wherein the first upper layer (60) comprises a first material and the second upper layer (70) comprises a second material, wherein the thermal conductivity of the first material is different from the thermal conductivity of the second material, wherein optionally the thermal conductivity of the first material is higher than the thermal conductivity of the second material.

14. The method (100; 200) or the electronic control unit (1; 2) according to any one of the preceding claims, wherein the integrated heat spreader (40, 50), the first integrated heat spreader (40), and/or the second integrated heat spreader (50) comprise aluminum, copper, ceramics, metal oxide, graphite, gold, silver and/or combinations thereof, wherein optionally the integrated heat spreader (40, 50), the first integrated heat spreader (40), and/or the second integrated heat spreader (50) comprise a cylindrical shape or a rectangular cuboid shape.

15. The method (100; 200) or the electronic control unit (1; 2) according to any one of the preceding claims, wherein the heat sink (80) is configured for passive and/or active heat exchange, wherein optionally the heat sink (80) is configured for a solid, a gaseous and/or a fluid heat exchange medium.

## Patentansprüche

1. Ein Verfahren (100) zum Herstellen einer elektronischen Steuereinheit (1; 2), wobei das Verfahren (100) die folgenden Schritte in der angegebenen Reihenfolge umfasst:
Bereitstellen (110) einer Leiterplatte (10) mit mindestens einer daran angebrachten elektrischen Komponente (12, 14);
Anordnen (120) einer unteren Schicht (20, 30) aus thermischem Grenzflächenmaterial auf der Oberseite der elektrischen Komponente (12, 14);
Anordnen (140) eines integrierten Wärmeverteilers (40, 50) auf der Oberseite der unteren Schicht (20, 30);
Bestimmen (150) des Abstands der oberen Oberfläche (41, 51) des integrierten Wärmeverteilers (40, 50) senkrecht zu der Leiterplatte (10);
Anordnen (160) einer oberen Schicht (60, 70) aus thermischem Grenzflächenmaterial auf der oberen Oberfläche (41, 51) des integrierten Wärmeverteilers (40, 50), wobei eine Schichtdicke der oberen Schicht (60, 70) basierend auf dem bestimmten Abstand ausgewählt wird, und
Anordnen (170) einer Wärmesenke (80) mit einer Kontaktfläche (81), so dass die Kontaktfläche (81) die obere Schicht (60, 70) kontaktiert.

2. Das Verfahren (100) gemäß dem vorhergehenden Anspruch, wobei das Verfahren (100) ferner den folgenden Schritt umfasst
Anbringen (130) eines Gehäuses (90) auf der Leiterplatte (10), wobei das Gehäuse (90) ein Durchgangsloch (92, 94) umfasst, das konfiguriert ist, um den integrierten Wärmeverteiler (40, 50) zumindest teilweise aufzunehmen, wobei der Schritt (130) optional vor dem Schritt des Anordnens (140) des integrierten Wärmeverteilers (40, 50) auf der Oberseite der unteren Schicht (20, 30) durchgeführt wird.

3. Das Verfahren (100) gemäß dem vorhergehenden Anspruch, wobei das Bestimmen des Abstands der oberen Oberfläche (41, 51) des integrierten Wärmeverteilers (40, 50) relativ zu der Leiterplatte (10) das Messen einer Höhendifferenz zwischen einer oberen Oberfläche (91) des Gehäuses (90) und der oberen Oberfläche (41, 51) des integrierten Wärmeverteilers (40, 50) umfasst.

4. Das Verfahren (100) gemäß einem der vorhergehenden Ansprüche, wobei die obere Schicht (60, 70)
ein thermisch leitfähiges komprimierbares Material und/oder
ein komprimierbares Material (61, 71) mit einer thermisch leitfähigen Wickelschicht (62, 72) umfasst, wobei die Wickelschicht (62, 72) optional eine Graphitschicht umfasst, wobei ferner optional die Graphitschicht eine Dicke hat, die in einem Bereich von 10 µm bis 40 µm und noch weiter optional von 20 µm bis 30 µm liegt.

5. Das Verfahren (100) gemäß einem der vorhergehenden Ansprüche, wobei die Schichtdicke der oberen Schicht (60, 70) in einem Bereich von 0,1 mm bis 10 mm, optional von 0,2 mm bis 5 mm, ferner optional von 0,4 mm bis 1,8 mm und noch weiter optional von 1 mm bis 1,2 mm liegt.

6. Das Verfahren (100) gemäß einem der vorhergehenden Ansprüche, wobei ein Verhältnis der Schichtdicke der oberen Schicht (60, 70) zu einer Schichtdicke der unteren Schicht (20, 30) in einem Bereich von 1 bis 60, optional von 1,5 bis 20, ferner optional von 1,8 bis 10, noch weiter optional von 2 bis 7 und noch weiter optional von 3 bis 5 liegt.

7. Ein Verfahren (200) zum Herstellen mehrerer elektronischer Steuereinheiten (1; 2), wobei das Verfahren (200) den folgenden Schritt umfasst:
mehrmaliges Wiederholen (210) der Verfahrensschritte des Verfahrens (100) gemäß einem der Ansprüche 1 bis 6 zum Herstellen mehrerer elektronischer Steuereinheiten, wobei jedes Mal ein integrierter Wärmeverteiler mit der gleichen Dicke angeordnet wird.

8. Das Verfahren (100; 200) gemäß einem der vorhergehenden Ansprüche, wobei ein erstes Material mit einer Wärmeleitfähigkeit K₁ für die obere Schicht (60, 70) ausgewählt wird, wenn ein Abstand d₁ der oberen Oberfläche (41, 51) des integrierten Wärmeverteilers (40, 50) senkrecht zu der Leiterplatte (10) bestimmt wird, wobei ein zweites Material mit einer Wärmeleitfähigkeit K₂, die höher als die Wärmeleitfähigkeit K₁ ist, für die obere Schicht (60, 70) ausgewählt wird, wenn ein Abstand d₂ der oberen Oberfläche (41, 51) des integrierten Wärmeverteilers (40, 50) senkrecht zu der Leiterplatte (10) bestimmt wird, wobei der Abstand d₂ größer als der Abstand d₁ ist.

9. Eine elektronische Steuereinheit (2), umfassend:
eine Leiterplatte (10) mit einer ersten (12) und einer zweiten (14) daran angebrachten elektrischen Komponente;
eine Wärmesenke (80) mit einer Kontaktfläche (81), die der Leiterplatte (10) zugewandt ist;
einen ersten integrierten Wärmeverteiler (40), der zwischen der ersten elektrischen Komponente (12) und der Wärmesenke (80) angeordnet ist, und einen zweiten integrierten Wärmeverteiler (50), der zwischen der zweiten elektrischen Komponente (14) und der Wärmesenke (80) angeordnet ist, wobei der erste integrierte Wärmeverteiler (40) im Wesentlichen die gleiche Dicke wie der zweite integrierte Wärmeverteiler (50) hat;
eine erste untere Schicht (20) aus thermischem Grenzflächenmaterial, die zwischen der ersten elektrischen Komponente (12) und dem ersten integrierten Wärmeverteiler (40) angeordnet ist, und eine zweite untere Schicht (30) aus thermischem Grenzflächenmaterial, die zwischen der zweiten elektrischen Komponente (14) und dem zweiten integrierten Wärmeverteiler (50) angeordnet ist, und
eine erste obere Schicht (60) aus thermischem Grenzflächenmaterial, die zwischen dem ersten integrierten Wärmeverteiler (40) und der Wärmesenke (80) angeordnet ist, und eine zweite obere Schicht (70) aus thermischem Grenzflächenmaterial, die zwischen dem zweiten integrierten Wärmeverteiler (50) und der Wärmesenke (80) angeordnet ist,
wobei die erste elektrische Komponente (12) weniger hoch ist als die zweite elektrische Komponente (14), wenn von der Leiterplatte (10) aus gemessen, und wobei die erste untere Schicht (20) dicker ist als die zweite untere Schicht (30) und/oder wobei die erste obere Schicht (60) dicker ist als die zweite obere Schicht (70).

10. Die elektronische Steuereinheit (2) gemäß dem vorhergehenden Anspruch, wobei die erste untere Schicht (20) im Wesentlichen die gleiche Dicke wie die zweite untere Schicht (30) hat und wobei die erste obere Schicht (60) dicker ist als die zweite obere Schicht (70).

11. Die elektronische Steuereinheit (2) gemäß einem der vorhergehenden Ansprüche, wobei die elektronische Steuereinheit (2) ferner umfasst
ein Gehäuse (90), das an der Leiterplatte (10) angebracht ist, wobei das Gehäuse (90) umfasst eine erste Öffnung (92), in der der erste integrierte Wärmeverteiler (40) zumindest teilweise angeordnet ist, und eine zweite Öffnung (94), in der der zweite integrierte Wärmeverteiler (50) zumindest teilweise angeordnet ist.

12. Die elektronische Steuereinheit (2) gemäß einem der vorhergehenden Ansprüche, wobei die erste (60) und/oder die zweite (70) obere Schicht umfassen
ein thermisch leitfähiges und komprimierbares Material und/oder
ein komprimierbares Material (61, 71) mit einer thermisch leitfähigen Wickelschicht (62, 72), wobei die Wickelschicht (62, 72) optional eine Graphitschicht umfasst, wobei ferner optional die Graphitschicht eine Dicke hat, die in einem Bereich von 10 µm bis 40 µm und noch weiter optional von 20 µm bis 30 µm liegt.

13. Die elektronische Steuereinheit (2) gemäß einem der vorhergehenden Ansprüche, wobei die erste obere Schicht (60) ein erstes Material umfasst und die zweite obere Schicht (70) ein zweites Material umfasst, wobei sich die Wärmeleitfähigkeit des ersten Materials von der Wärmeleitfähigkeit des zweiten Materials unterscheidet, wobei optional die Wärmeleitfähigkeit des ersten Materials höher ist als die Wärmeleitfähigkeit des zweiten Materials.

14. Das Verfahren (100; 200) oder die elektronische Steuereinheit (1; 2) gemäß einem der vorhergehenden Ansprüche, wobei der integrierte Wärmeverteiler (40, 50), der erste integrierte Wärmeverteiler (40) und/oder der zweite integrierte Wärmeverteiler (50) Aluminium, Kupfer, Keramik, Metalloxid, Graphit, Gold, Silber und/oder Kombinationen davon umfassen, wobei optional der integrierte Wärmeverteiler (40, 50), der erste integrierte Wärmeverteiler (40) und/oder der zweite integrierte Wärmeverteiler (50) eine zylindrische Form oder eine rechteckige Quaderform umfassen.

15. Das Verfahren (100; 200) oder die elektronische Steuereinheit (1; 2) gemäß einem der vorhergehenden Ansprüche, wobei die Wärmesenke (80) für einen passiven und/oder aktiven Wärmeaustausch konfiguriert ist, wobei optional die Wärmesenke (80) für ein festes, ein gasförmiges und/oder ein fluides Wärmeaustauschmedium konfiguriert ist.

## Revendications

1. Un procédé (100) pour la fabrication d'une unité de contrôle électronique (1 ; 2), le procédé (100) comprenant, dans cet ordre, les étapes suivantes :
l'obtention (110) d'une carte de circuit imprimé (10) avec au moins un composant électrique (12, 14) fixé dessus ;
la mise en place (120) d'une couche inférieure (20, 30) de matériau d'interface thermique par-dessus le composant électrique (12, 14) ;
la mise en place (140) d'un diffuseur de chaleur intégré (40, 50) par-dessus la couche inférieure (20, 30) ;
la détermination (150) de la distance à la surface de dessus (41, 51) du diffuseur de chaleur intégré (40, 50) perpendiculairement à la carte de circuit imprimé (10) ;
la mise en place (160) d'une couche supérieure (60, 70) de matériau d'interface thermique sur la surface de dessus (41, 51) du diffuseur de chaleur intégré (40, 50), une épaisseur de couche de la couche supérieure (60, 70) étant choisie sur la base de la distance déterminée, et
la mise en place d'un drain de chaleur (80) avec une surface de contact (81) telle que la surface de contact (81) vienne en contact avec la couche supérieure (60, 70).

2. Le procédé (100) selon la revendication précédente, dans lequel le procédé (100) comprend en outre l'étape de :
fixation (130) d'un boîtier (90) sur la carte de circuit imprimé (10), le boîtier (90) comprenant un orifice traversant (82, 94) qui est configuré pour recevoir au moins partiellement le diffuseur de chaleur intégré (40, 50), ladite étape (130) étant éventuellement exécutée avant l'étape de mise en place (40) du diffuseur de chaleur intégré (40, 50) par-dessus la couche inférieure (20, 30).

3. Le procédé (100) selon la revendication précédente, dans lequel la détermination de la distance à la surface de dessus (41, 51) du diffuseur de chaleur intégré (40, 50) par rapport à la carte de circuit intégré (10) comprend la mesure d'une différence de hauteur entre une surface de dessus (91) du boîtier (90) et la surface de dessus (41, 51) du diffuseur de chaleur intégré (40, 50).

4. Le procédé (100) selon l'une des revendications précédentes, dans lequel la couche supérieure (60, 70) comprend :
un matériau compressible thermiquement conducteur, et/ou
un matériau compressible (61, 71) avec une couche d'enveloppement thermiquement conductrice (62, 72), la couche d'enveloppement (62, 72) comprenant éventuellement une couche de graphite, la couche de graphite ayant en outre éventuellement une épaisseur qui s'étend dans une plage allant de 10 µm à 40 µm et encore en outre éventuellement de 20 µm à 30 µm.

5. Le procédé (100) selon l'une des revendications précédentes, dans lequel l'épaisseur de couche de la couche supérieure (60, 70) s'étend dans une plage allant de 0,1 mm à 10 mm, éventuellement de 0,2 mm à 5 mm, en outre éventuellement de 0,4 mm à 1,8 mm et encore en outre éventuellement de 1 mm à 1,2 mm.

6. Le procédé (100) selon l'une des revendications précédentes, dans lequel un ratio entre l'épaisseur de couche de la couche supérieure (60, 70) et une épaisseur de couche de la couche inférieure (20, 30) s'étend dans une plage allant de 1 à 60, éventuellement de 1,5 à 20, en outre éventuellement de 1,8 à 10, encore en outre éventuellement de 2 à 7, et encore plus éventuellement de 3 à 5.

7. Un procédé (200) de fabrication de multiples unités de contrôle électronique (1 ; 2), le procédé (200) comprenant l'étape de :
répétition (210) de multiples fois des étapes de procédé du procédé (100) selon l'une des revendications 1 à 6 pour la fabrication de multiples unités de contrôle électronique, avec à chaque fois mise en place d'un diffuseur de chaleur intégré ayant la même épaisseur.

8. Le procédé (100 ; 200) selon l'une des revendications précédentes, dans lequel un premier matériau avec une conductivité thermique K₁ est choisi pour la couche supérieure (60, 70) si une distance d₁ à la surface de dessus (41, 51) du diffuseur de chaleur intégré (40, 50) perpendiculairement à la carte de circuit imprimé est déterminée, dans lequel un second matériau avec une conductivité thermique K₂ qui est supérieure à la conductivité thermique K₁ est choisi pour la couche supérieure (60, 70) si une distance d₂ à la surface de dessus (41, 51) du diffuseur de chaleur intégré (40, 50) perpendiculairement à la carte de circuit imprimé (10) est déterminée, la distance d₂ étant supérieur à la distance d₁.

9. Une unité de contrôle électronique (2), comprenant :
une carte de circuit imprimé (10) avec un premier (12) et un second (14) composant électrique fixés dessus ;
un drain de chaleur (80) avec une surface de contact (81) tournée vers la carte de circuit imprimé (10) ;
un premier diffuseur de chaleur intégré (40) disposé entre le premier composant électrique (12) et le drain de chaleur (80), et un second diffuseur de chaleur intégré (50) disposé entre le second composant électrique (14) et le drain de chaleur (80), le premier diffuseur de chaleur intégré (40) ayant sensiblement la même épaisseur que le second diffuseur de chaleur intégré (50) ;
une première couche inférieure (20) de matériau d'interface thermique disposée entre le premier composant électrique (12) et le premier diffuseur de chaleur intégré (40), et une seconde couche (30) de matériau d'interface thermique disposée entre le second composant électrique (14) et le second diffuseur de chaleur intégré (50) ; et
une première couche supérieure (60) de matériau d'interface thermique disposée entre le premier diffuseur de chaleur intégré (40) et le drain de chaleur (80), et une seconde couche supérieure (70) de matériau d'interface thermique disposée entre le second diffuseur de chaleur intégré (50) et le drain de chaleur (80),
dans laquelle le premier composant électrique (12) est moins haut que le second composant électrique (14) lorsqu'ils sont mesurés depuis la carte de circuit intégré (10), et dans laquelle la première couche inférieure (20) est plus épaisse que la seconde couche inférieure (30) et/ou dans laquelle la première couche supérieure (60) est plus épaisse que la seconde couche supérieure (70).

10. L'unité de contrôle électronique (2) selon la revendication précédente, dans laquelle la première couche inférieure (20) a sensiblement la même épaisseur que la seconde couche inférieure (30), et dans laquelle la première couche supérieure (60) est plus épaisse que la seconde couche supérieure (70).

11. L'unité de contrôle électronique (2) selon l'une des revendications précédentes, dans laquelle l'unité de contrôle électronique (2) comprend en outre :
un boîtier (90) fixé à la carte de circuit imprimé (10), le boîtier (90) comprenant une première ouverture (92) dans laquelle est au moins partiellement disposé le premier diffuseur de chaleur intégré (40) et une seconde ouverture (94) dans laquelle est au moins partiellement disposé le second diffuseur de chaleur intégré (50).

12. L'unité de contrôle électronique (2) selon l'une des revendications précédentes, dans laquelle la première (60) et/ou la seconde (70) couche supérieure comprennent :
un matériau thermiquement conducteur et compressible ; et/ou
un matériau compressible (61, 71) avec une couche d'enveloppement thermiquement conductrice (62, 72), la couche d'enveloppement (62, 72) comprenant éventuellement une couche de graphite, la couche de graphite ayant en outre éventuellement une épaisseur qui s'étend dans une plage allant de 10 µm à 40 µm et encore en outre éventuellement de 20 µm à 30 µm.

13. L'unité de contrôle électronique (2) selon l'une des revendications précédentes, dans laquelle la première couche supérieure (60) comprend un premier matériau et une seconde couche supérieure (70) comprend un second matériau, la conductivité thermique du premier matériau étant différente de la conductivité thermique du second matériau, la conductivité du premier matériau étant éventuellement supérieure à la conductivité thermique du second matériau.

14. Le procédé (100 ; 200) ou l'unité de contrôle électronique (1 ; 2) selon l'une des revendications précédentes, dans lesquels le diffuseur de chaleur intégré (40, 50), le premier diffuseur de chaleur intégré (40), et/ou le second diffuseur de chaleur intégré (50) comprennent de l'aluminium, du cuivre, de la céramique, un oxyde métallique, du graphite, de l'or, de l'argent, et/ou des combinaisons des précédents, le diffuseur de chaleur intégré (40), 50), le premier diffuseur de chaleur intégré (40), et/ou le second diffuseur de chaleur intégré (50) présentant éventuellement une forme cylindrique ou une forme parallélépipédique rectangle.

15. Le procédé (100 ; 200) ou l'unité de contrôle électronique (1 ; 2) selon l'une des revendications précédentes, dans lesquels le drain de chaleur (80) est configuré pour un échange de chaleur passif et/ou actif, dans lesquels le drain de chaleur (80) est éventuellement configuré pour un milieu d'échange de chaleur solide, gazeux, et/ou fluide.
